# EUROPÄISCHE PATENTSCHRIFT

(11) **EP 3 894 317 B1**
(45) Veröffentlichungstag und Bekanntmachung des Hinweises auf die Patenterteilung: **26.10.2022**
(21) Anmeldenummer: 19813752.3
(22) Anmeldetag: 28.11.2019
(51) Int. Cl.: B63G 9/06, H01F 13/00

(54) **ENTMAGNETISIERUNGS- UND SIGNATURVERMESSUNGSANLAGE**
DEMAGNETIZATION AND SIGNATURE MEASUREMENT SYSTEM
DISPOSITIF DE DÉMAGNÉTISATION ET DE MESURE DE LA SIGNATURE

(30) Priorität: 10.12.2018 DE 102018131564
(43) Veröffentlichungstag der Anmeldung: 20.10.2021
(73) Patentinhaber: STL Systems AG, 8274 Tägerwilen (CH)
(72) Erfinder: LUDWIG, Wolfgang, 8274 Tägerwilen (CH); LUDWIG, Stefan, 8500 Frauenfeld (CH); LUDWIG, Christoph, 78462 Konstanz (DE); KAMA, Sezgin, 25524 Itzehoe (DE); STEINFORT, Adrianus J., 8280 Kreuzlingen (CH)
(74) Vertreter: Patent- und Rechtsanwälte Behrmann Wagner PartG mbB
(86) Internationale Anmeldenummer: PCT/EP2019/082836
(87) Internationale Veröffentlichungsnummer: WO 2020/120145

(56) Entgegenhaltungen:
- WO-A1-2013/038377
- FR-A1- 2 620 419
- FR-A1- 2 698 698
- KR-B1- 101 614 039

## Beschreibung

Die Erfindung betrifft eine Vorrichtung zur Entmagnetisierung und magnetischen Signaturvermessung eines stationär befindlichen Schiffskörpers und zur Simulation eines Magnetfeldes, mit einer Entmagnetisierspulen-Anordnung, einer Magnetfeldsensor-Anordnung und einer Simulationsspulen-Anordnung.

Bekannt sind Entmagnetisierungsanlagen für Schiffe, insbesondere für den militärischen Bereich, bei denen die Magnetisierung des Schiffskörpers vermindert wird, um diese Schiffe beispielsweise für Magnetminen mit Magnetzünder schwerer auffindbar zu machen. Neben der Funktion der Entmagnetisierung sind derartige Anlagen auch zur Signaturmessung ausgestattet, wobei ein vom natürlichen Umgebungsfeld unterschiedliches Erdmagnetfeld simuliert werden kann, um für dieses den gewünschten Entmagnetisierungszustand des Schiffs zu erreichen. Weiterhin verfügen diese Anlagen in der Regel über die Funktion der Signaturmessung, mit der die magnetische Signatur des Schiffes aufgenommen und ausgewertet werden kann. Diese Signatur liefert bei Schiffen ein Maß für die Entdeckbarkeit des Schiffskörpers durch einen Magnetfeldsensor beispielsweise bei oben genannten Magnetminen oder dient zur Einstellung der schiffseigenen Entmagnetisierungsanlage.

Aus dem Stand der Technik sind Entmagnetisierungsanlagen bekannt, bei denen sich das Schiff über eine oder mehrere Entmagnetisierspule(n) bewegt, die ein starkes magnetisches Feld vornehmlich in vertikale Richtung erzeugt/(erzeugen). Die Entmagnetisierspulen sind fest in einer Tiefe von ca. 8m bis 12m in horizontaler Lage in einer im Boden verankerten Haltestruktur etabliert, sodass ihre Flächennormalen vertikal zum Erdmittelpunkt ausgerichtet sind. Durch langsames Überfahren der Anlage wird das von den Spulen erzeugte Wechselfeld konstanter Amplitude in ein magnetisches Wechselfeld mit anwachsender und abfallender Amplitude umgewandelt und somit die Entmagnetisierung bewirkt.

Zur Simulation eines Magnetfeldes wird in gleicher Weise ein Satz Simulationsspulen in eine im Boden verankerte Struktur eingelassen, die ebenfalls ein vornehmlich vertikal ausgerichtetes stationäres Magnetfeld gewünschter Feldstärke ausbilden. Bei dem Entmagnetisiervorgang werden in der Regel das Simulationsspulensystem und das Entmagnetisierspulensystem gleichzeitig betrieben.

Die Signaturvermessung erfolgt häufig durch Magnetfeld-Sensorzeilen, wobei sich durch die Überfahrt über die Sensorzeilen zweidimensionale Magnetfeldkarten ergeben, die die Magnetisierung des Schiffs widerspiegeln.

Zwar erweisen sich derartige zur Überfahrt geeignete Anlagen als vergleichsweise kostengünstig, weisen jedoch betriebsmäßige Nachteile auf. Nachteilig ist insbesondere, neben der Einschränkung hinsichtlich des Standorts wegen der Ausrichtung der Anlage an dem Erdmagnetfeld, vor allem der große Zeitaufwand beim Signaturmessprozess aufgrund einer mehrfachen Überfahrt in unterschiedlichen Richtungen sowie die Tatsache, dass bezüglich der Längsrichtung des Schiffskörpers nur Querfelder und Vertikalfelder für die Simulation erzeugt werden. Das äußert sich z.B. darin, dass durch die natürliche Wanderung des Erdmagnetfeldvektors die Anlage nicht mehr wie bei ihrer Erstellung auf das Erdmagnetfeld ausgerichtet ist und daher die Qualität der Entmagnetisier- und Signaturmessergebnisse nachlässt. Ein weiterer gravierender Nachteil besteht darin, dass das Entmagnetisierfeld vom Tidenhub abhängt, da sich der Abstand zwischen Schiff und Entmagnetisierspule mit dem Wasserstand ändert. Bei einem Tidenhub von über 2m können wesentliche Einschränkungen für die Nutzung der Anlage entstehen.

Weiterhin sind beispielsweise aus der WO 2013/038377 käfigförmige Anlagen bekannt, bei denen sich das Schiff stationär im Innenraum eines aus Spulen gebildeten Käfigs befindet. Diese Anlagen sind meist quaderförmig aufgebaut und in der Lage, das Schiff als Ganzes aufzunehmen. Die Orientierung dieser Anlagen in Bezug auf das Erdmagnetfeld ist beliebig, weil in dem Innenraum des Käfigs zur Magnetfeld-Simulation homogene Magnetfelder in allen drei Raumrichtungen erzeugt werden können. Die Entmagnetisierfelder werden in Längsrichtung des Schiffskörpers erzeugt und sind damit besonders wirksam.

Als nachteilig erweist sich bei diesem Anlagentyp, dass hohe Kosten infolge der Anlagengröße verursacht werden, insbesondere erfordern Schiffe mit hohen Aufbauten sehr große Anlagen. Daneben ist eine hohe Entmagnetisierungsleistung wegen des großen Entmagnetisierungsvolumens erforderlich und es werden zur Entmagnetisierung wegen der Anordnung des Schiffskörpers in Längsrichtung des Spuleninnenraums nur Längsfelder erzeugt.

Der vorliegenden Erfindung liegt somit die Aufgabe zugrunde, eine Entmagnetisierungsanlage mit hoher Entmagnetisierungseffizienz und im Vergleich zu bestehenden Anlagen günstigen Erstellungs- und Betriebskosten vorzuschlagen.

Diese Aufgabe wird in Verbindung mit den Merkmalen des Oberbegriffs in Anspruch 1 dadurch gelöst, dass die Vorrichtung - in Bezug auf ein in die Vorrichtung einfahrendes Schiff - in Längsrichtung des Schiffskörpers horizontal einseitig neben dem Schiffskörper positionierbar ist, wobei die Entmagnetisierspulen-Anordnung mindestens zwei Entmagnetisierspulen aufweist, deren Querschnittsflächen in Längsrichtung des Schiffskörpers nebeneinander angeordnet und deren Flächennormalen horizontal ausgerichtet sind, sodass außerhalb der Entmagnetisierspulen ein in Längsrichtung des Schiffskörpers fortschreitendes magnetisches Wechselfeld erzeugt wird. Anstelle von mindestens zwei Entmagnetisierspulen, bei denen ein magnetisches Wanderfeld erzeugt wird, kann auch eine einzige Entmagnetisierspule verwendet werden, deren Länge sich über die ganze Schiffslänge erstreckt und deswegen kein Wanderfeld mehr erzeugt wird.

Erfindungsgemäß sind die Entmagnetisierspulen, beispielsweise an einem Landungssteg oder einer Kaimauer, so angeordnet, dass ihre Flächennormalen horizontal ausgerichtet sind. Der Schiffskörper wird somit nicht von unten her, sondern durch an einer Längsseite des Schiffs eintretende Magnetfeldlinien entmagnetisiert. Dabei sind die Entmagnetisierspulen entlang einer Längsseite des Schiffes angeordnet, sodass ein in Längsrichtung des Schiffskörpers fortschreitendes magnetisches Wechselfeld erzeugbar ist. Die Vorbeifahrt des Schiffes an der Entmagnetisierspulen-Anordnung ist nicht erforderlich und wird bei zwei oder mehr Entmagnetisierungsspulen durch ein magnetisches Wanderfeld ersetzt, das sich an dem stationär befindlichen Schiffskörper vorbeibewegt.

Neben dem Vorteil des fest vertäuten (stationär befindlichen) Schiffes besteht der Vorteil darin, dass kurze Entmagnetisierungszeiten in Verbindung mit vergleichsweise niedrigen Kosten wegen der kompakten Entmagnetisierspulen-Anordnung auftreten. Die Entmagnetisierspulen-Anordnung kann in einfacher Weise an einem Landungssteg oder einer Kaimauer befestigt oder darin integriert sein.

In weiterer Ausgestaltung weist das fortschreitende magnetische Wechselfeld bezüglich der Längsrichtung des Schiffskörpers eine im Wesentlichen horizontale Wechselfeld-Querkomponente und/oder eine Wechselfeld-Längskomponente auf. Im letzteren Fall sind zum Fortschreiten mindestens drei Entmagnetisierspulen erforderlich.

Neben der für den Entmagnetisierungsprozess besonders wirksamen Wechselfeld-Längskomponente eignet sich die erfindungsgemäße Vorrichtung zur Erzeugung einer horizontalen Wechselfeld-Querkomponente. Die horizontale Wechselfeld-Querkomponente und die Wechselfeld-Längskomponente bewirken eine hohe Entmagnetisierungseffizienz.

Mit Vorteil weist die Simulationsspulen-Anordnung Simulationsspulen auf, deren Querschnittsflächen in Längsrichtung des Schiffskörpers nebeneinander angeordnet und deren Flächennormalen horizontal ausgerichtet sind, sodass außerhalb der Simulationsspulen ein stationäres Simulationsmagnetfeld mit einer Vertikalkomponente, einer Querkomponente und einer Längskomponente bezüglich der Längsrichtung des Schiffskörpers erzeugbar sind.

Die Simulationsspulen-Anordnung umfasst Simulationsspulen, die in gleicher Weise wie die Entmagnetisierspulen ausgerichtet sind. Damit können in sehr flexibler Weise gewünschte stationäre Magnetfeldstrukturen mit Magnetfeld-Komponenten in allen drei Raumrichtungen simuliert und z.B. das Erdmagnetfeld unabhängig von der geometrischen Ausrichtung der Anlage kompensiert werden. Die Simulationsspulen-Anordnung weist bevorzugt mindestens fünf Simulationsspulen auf, wobei mindestens zwei gegensinnig wirkende Simulationsspulen zur Erzeugung der Vertikalkomponente, mindestens eine Simulationsspule zur Erzeugung der Querkomponente und mindestens zwei gegensinnig wirkende Simulationsspulen zur Erzeugung der Längskomponente des Simulationsmagnetfeldes dienen.

Zwei gegensinnig betriebene, in Längsrichtung des Schiffskörpers nebeneinander angeordnete Simulationsspulen erzeugen eine Längskomponente des Simulationsmagnetfeldes, zwei in vertikaler Richtung übereinander angeordnete Simulationsspulen erzeugen die Vertikalkomponente des Simulationsmagnetfeldes. Zur Erzeugung der Querkomponente des Simulationsmagnetfeldes reicht eine Simulationsspule aus.

Zur Vermessung der magnetischen Signatur weist die Magnetfeldsensor-Anordnung Magnetfeldsensoren auf, die z.B. in einer Ebene der jeweiligen Querschnittsfläche der Entmagnetisierspulen und/oder Simulationsspulen angeordnet sind.

Bevorzugt befinden sich die Magnetfeldsensoren in einer Ebene der jeweiligen Querschnittsfläche der Entmagnetisierungsspulen und/oder der Simulationsspulen, um das an dem Ort der entsprechenden Spulen vorherrschende Magnetfeld des Schiffes zu analysieren.

In bevorzugter Ausgestaltung ist die erfindungsgemäße Vorrichtung an einem nicht magnetischen Landungssteg und/oder einer Kaimauer befestigt oder darin integriert.

Zur wirksameren Entmagnetisierung und zur genaueren Magnetfeld-Simulation sind zwei erfindungsgemäße Vorrichtungen horizontal an gegenüberliegenden Seiten in Längsrichtung des Schiffskörpers positionierbar.

In dieser Ausgestaltung kann jeweils eine erfindungsgemäße Vorrichtung an einem Landungssteg oder einer Kaimauer angeordnet sein, wobei sich der Schiffskörper zwischen zwei Landungsstegen bzw. Landungssteg und der Kaimauer mit den erfindungsgemäßen Vorrichtungen stationär befindet.

Für die Entmagnetisierung von Schiffen in getauchter Position kann die Anlage an einem höhenverstellbaren Landungssteg oder höhenverstellbar an einem fixen Landungssteg oder einer Kaimauer so montiert werden, dass sich die Spulen in ihrer ganzen Größe unter Wasser befinden.

Das Entmagnetisiersystem kann auch in ein Schwimmdock oder Trockendock integriert werden, das in nicht magnetischer Bauweise ausgeführt wird und auch die gesamte elektrische/elektronische Einrichtung wie z.B. Stromgeneratoren, Stromquellenerzeuger und Signalverarbeitungssysteme aufweist. Bei großen Schiffsbreiten ist es vorteilhaft, wenn auf dem Boden des Docks noch eine dritte Anordnung von Entmagnetisierspulen integriert wird, um die Entmagnetisierfeldstärke zu erhöhen.

Weitere vorteilhafte Ausgestaltungsmerkmale ergeben sich aus der nachfolgenden Beschreibung und den Zeichnungen, die bevorzugte Ausführungsformen der Erfindung anhand von Beispielen erläutern.

Es zeigen:
- Fig. 1: eine schematische Darstellung der erfinderischen Vorrichtung in Draufsicht,
- Fig. 2: eine schematische Darstellung der ersten erweiterten erfinderischen Vorrichtung in Draufsicht,
- Fig. 3: eine schematische Darstellung der erfinderischen Vorrichtung nach Fig. 1 in dreidimensionaler Darstellung,
- Fig. 4: eine schematische Darstellung der Entmagnetisierspulen-Anordnung mit Magnetfeldsensoren in Seitenansicht,
- Fig. 5: eine schematische Darstellung der Simulationsspulen-Anordnung in Seitenansicht,
- Fig. 6a, Fig. 6b, Fig. 6c: eine Erzeugung der Magnetfeldkomponenten des Simulationsmagnetfeldes,
- Fig. 7: eine Erzeugung der Wechselfeld-Längskomponente des fortschreitenden magnetischen Wechselfeldes und
- Fig. 8: eine Erzeugung der horizontalen WechselfeldQuerkomponente des fortschreitenden magnetischen Wechselfeldes.

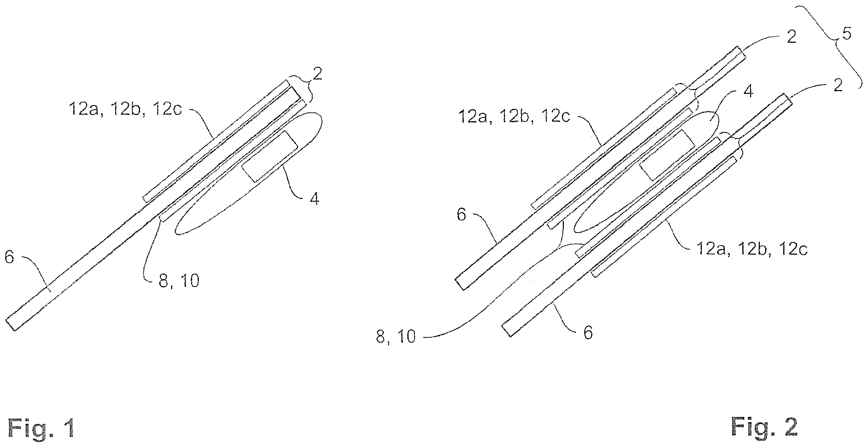

Die Fig. 1 zeigt schematisch die Positionierbarkeit der erfindungsgemäßen Vorrichtung 2 in Bezug auf einen stationär befindlichen Schiffskörper 4. Durch Anlegen und festes Vertäuen des Schiffskörpers 4 an einem nicht magnetischen Landungssteg 6 kann die erfindungsgemäße Vorrichtung 2 so positioniert werden, dass sie sich horizontal einseitig neben dem Schiffskörper 4 befindet. Der Schiffskörper 4 wird somit während des Entmagnetisierungsvorgangs und während der magnetischen Signaturvermessung sowie zur Simulation des Magnetfeldes nicht an der Vorrichtung 2 vorbei bewegt, sondern bleibt stationär. An dem Landungssteg 6 befestigt oder in diesem integriert ist die erfindungsgemäße Vorrichtung 2, die aus der Entmagnetisierspulen-Anordnung 8 mit Magnetfeldsensoren 10 sowie aus der Simulationsspulen-Anordnung 12a, 12b, 12c besteht. Die Entmagnetisierspulen-Anordnung 8 mit den Magnetfeldsensoren 10 sowie die Simulationsspulen-Anordnung 12a, 12b, 12c können in beliebiger Weise an dem Landungssteg befestigt oder in diesem integriert sein, sind jedoch immer so angeordnet, dass deren Querschnittsflächen mit ihren Flächennormalen horizontal (hier in Zeichenebene) ausgerichtet sind.

Fig. 2 zeigt in schematischer Darstellung die erste erweiterte erfinderische Vorrichtung 5, die aus zwei erfinderischen Vorrichtungen 2 besteht, die horizontal einseitig an gegenüberliegenden Seiten neben dem Schiffskörper 4 positionierbar sind.

In dieser ersten erweiterten Ausführungsform 5 befindet sich der Schiffskörper 4 zwischen zwei Landungsstegen 6 mit den jeweiligen Vorrichtungen 2.

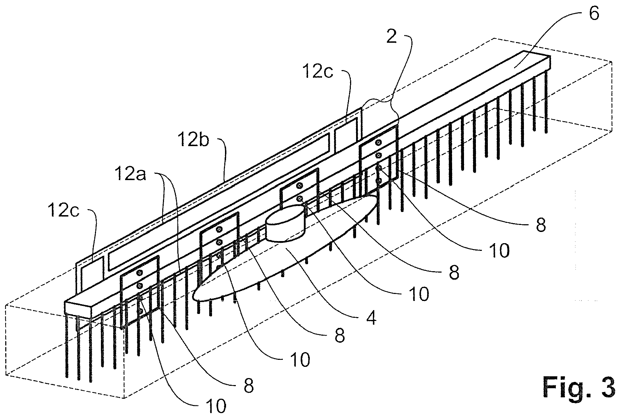

Fig. 3 zeigt eine schematische Darstellung der erfinderischen Vorrichtung 2 aus Fig. 1 in dreidimensionaler Ansicht. In Längsrichtung des Schiffskörpers 4 in einer Ebene nebeneinander angeordnet befinden sich die vier Entmagnetisierspulen 8 mit in einer jeweiligen Spulenebene der Entmagnetisierspulen 8 angeordneten vier Magnetfeldsensoren 10. In einer Ebene auf der gegenüberliegenden Seite des Landungsstegs 6 sind insgesamt fünf Simulationsspulen 12a, 12b, 12c angeordnet.

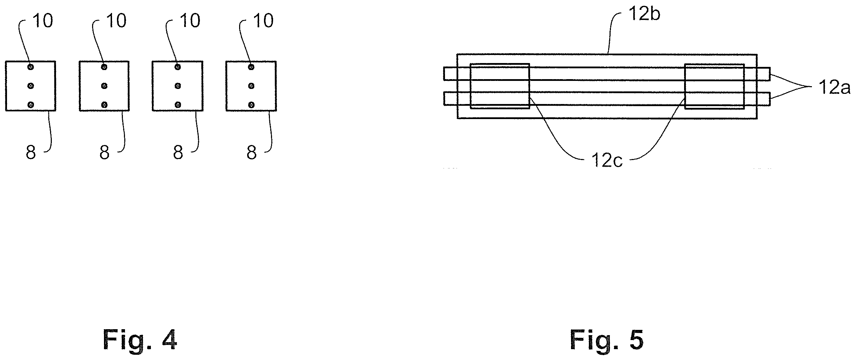

Fig. 4 zeigt in schematischer Darstellung die Ebene der Entmagnetisierspulen-Anordnung mit vier Entmagnetisierspulen 8, hier mit jeweils drei Magnetfeldsensoren 10. Zur Erzeugung des fortschreitenden magnetischen Wechselfeldes sind mindestens zwei Entmagnetisierspulen 8 erforderlich. Zur Signaturvermessung umfasst jeweils eine Entmagnetisierspule 8 mindestens zwei Magnetfeldsensoren 10.

Fig. 5 ist eine schematische Darstellung der aus mindestens fünf Simulationsspulen 12a, 12b, 12c bestehenden Simulationsspulen-Anordnung.

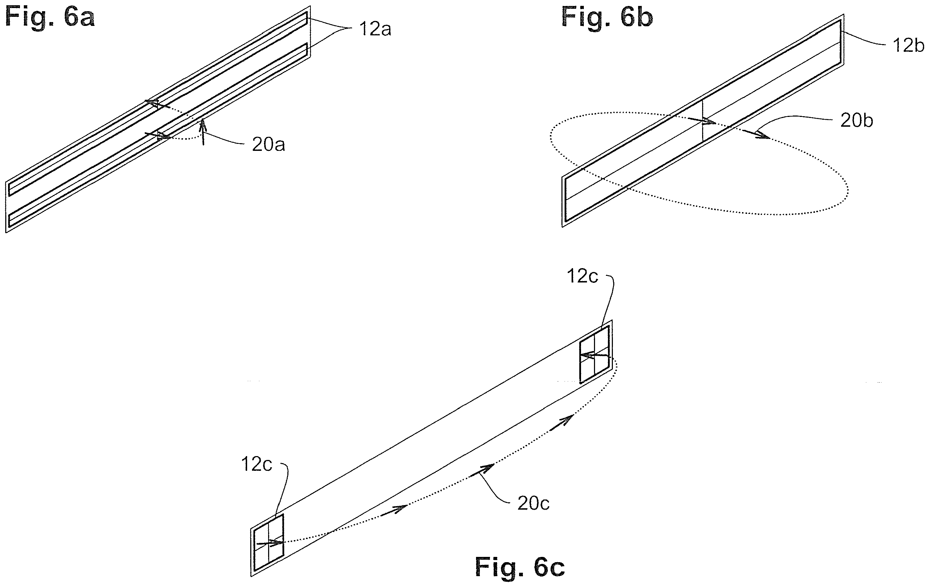

In den Fig. 6a, 6b und 6c ist dargestellt, wie diese Spulen zur Erzeugung eines stationären Simulationsmagnetfeldes beitragen.

Fig. 6a zeigt die vertikal nebeneinander angeordneten Simulationsspulen 12a zur Erzeugung einer Vertikalkomponente 20a des Simulationsmagnetfeldes.

Fig. 6b zeigt die durch eine Simulationsspule 12b erzeugte Querkomponente 20b des stationären Simulationsmagnetfeldes.

In Fig. 6c ist das aus den Simulationsspulen 12c gebildete Spulenpaar dargestellt, welches eine Längskomponente 20c des stationären Simulationsmagnetfeldes erzeugt.

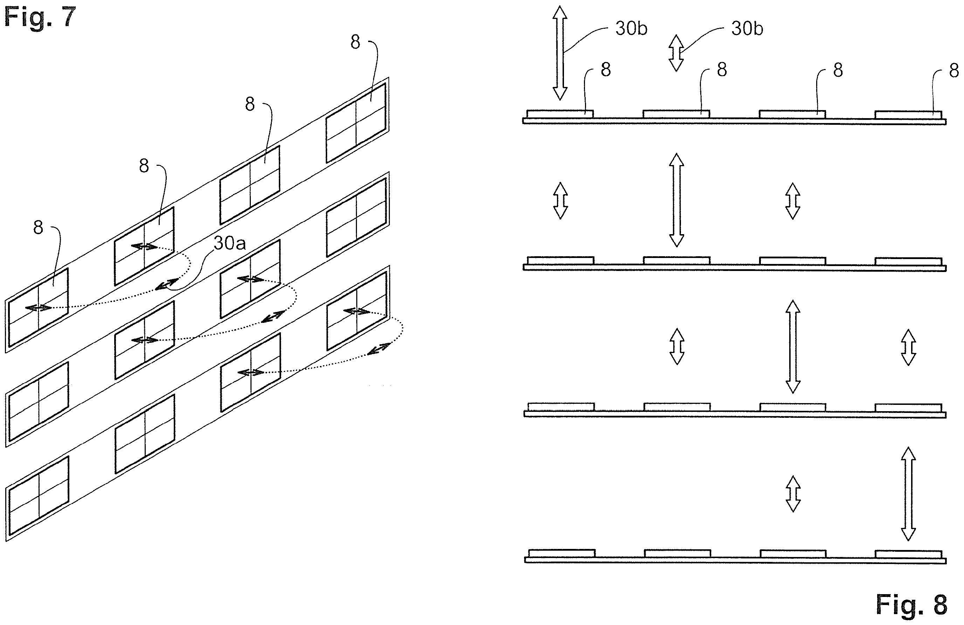

In Fig. 7 ist die Erzeugung eines in Längsrichtung orientierten fortschreitenden Entmagnetisierwechselfeldes (Wechselfeld-Längskomponente 30a) außerhalb der Spulenebene durch jeweils zwei benachbarte, gegensinnig betriebene Entmagnetisierspulen 8 dargestellt.

In der oberen Zeile befindet sich das Maximum der Feldamplitude der Wechselfeld-Längskomponente 30a im linken Spulenbereich, in der mittleren Zeile im mittleren Spulenbereich und in der unteren Zeile im rechten Spulenbereich. Durch eine entsprechende Stromsteuerung und die damit bewirkte Anregung der jeweiligen Entmagnetisierspulen 8 wandert das Maximum der Wechselfeld-Längskomponente 30a in Längsrichtung der Entmagnetisierspulen-Anordnung und damit in Längsrichtung an dem Schiffskörper 4 vorbei.

Fig. 8 zeigt die Erzeugung eines in Querrichtung orientierten fortschreitenden Entmagnetisierwechselfeldes (horizontale Wechselfeld-Querkomponente 30b) außerhalb der Spulenebene durch mehrere benachbarte gleichsinnig betriebene Entmagnetisierspulen 8.

In der oberen Zeile befindet sich das Maximum der Feldamplitude der horizontalen Wechselfeldquerkomponente 30b im linken Spulenbereich. Wie in den darunterliegenden Zeilen dargestellt, wandert das Maximum der horizontalen Wechselfeld-Querkomponente 30b durch geeignete Stromansteuerung und der damit verbundenen Anregung der betreffenden Entmagnetisierspulen 8 in Längsrichtung an der Entmagnetisierspulen-Anordnung nach rechts und damit in Längsrichtung an dem Schiffskörper 4 vorbei.

### Bezugszeichenliste

- 2: Vorrichtung
- 4: Schiffskörper
- 5: erweiterte Vorrichtung
- 6: Landungssteg
- 8: Entmagnetisierspulen-Anordnung
- 10: Magnetfeldsensoren
- 12a/b/c: Simulationsspulen
- 20a: Vertikalkomponente
- 20b: Querkomponente
- 20c: Längskomponente
- 30a: Wechselfeld-Längskomponente
- 30b: Wechselfeld-Querkomponente

## Patentansprüche

1. Vorrichtung (2) zur Entmagnetisierung und magnetischen Signaturvermessung eines stationär befindlichen Schiffskörpers (4) und zur Simulation eines Magnetfeldes (20a, 20b, 20c), mit einer Entmagnetisierspulen-Anordnung (8), einer Magnetfeldsensor-Anordnung (10) und einer Simulationsspulen-Anordnung (12a, 12b, 12c),
**gekennzeichnet durch**
eine Positionierbarkeit der Vorrichtung (2) in Längsrichtung des Schiffskörpers (4) horizontal einseitig neben dem Schiffskörper (4), wobei die Entmagnetisierspulen-Anordnung (8) eine einzige Entmagnetisierspule (8) aufweist, deren Querschnittsfläche sich mindestens über die gesamte Länge des Schiffskörpers (4) erstreckt und deren Flächennormale orthogonal zur Längsrichtung des Schiffskörpers (4) ausgerichtet ist, sodass außerhalb der Entmagnetisierspule (8) ein feststehendes magnetisches Wechselfeld erzeugbar ist, oder mindestens zwei Entmagnetisierspulen (8) aufweist, deren Querschnittsflächen in Längsrichtung des Schiffskörpers (4) nebeneinander angeordnet und deren Flächennormalen orthogonal zur Längsrichtung des Schiffskörpers (4) ausgerichtet sind, sodass außerhalb der Entmagnetisierspulen (8) ein in Längsrichtung des Schiffskörpers (4) fortschreitendes magnetisches Wechselfeld (30a, 30b) erzeugbar ist.

2. Vorrichtung nach Anspruch 1,
**dadurch gekennzeichnet,**
**dass** das fortschreitende magnetische Wechselfeld (30a, 30b) bezüglich der Längsrichtung des Schiffskörpers (4) eine horizontale Wechselfeld-Querkomponente (30b) und eine Wechselfeld-Längskomponente (30a) aufweist.

3. Vorrichtung nach Anspruch 1 oder 2,
**dadurch gekennzeichnet,**
**dass** die Querschnittsflächen der Simulationsspulen (12a, 12b, 12c) in Längsrichtung des Schiffskörpers (4) nebeneinander angeordnet und deren Flächennormalen horizontal ausgerichtet sind, sodass außerhalb der Simulationsspulen (12a, 12b, 12c) ein stationäres Simulations-Magnetfeld (20a, 20b, 20c) mit einer Vertikalkomponente (20a), einer Querkomponente (20b) und einer Längskomponente (20c) bezüglich der Längsrichtung des Schiffskörpers (4) erzeugbar ist.

4. Vorrichtung nach Anspruch 3,
**dadurch gekennzeichnet,**
**dass** die Simulationsspulen-Anordnung (12a, 12b, 12c) mindestens fünf Simulationsspulen (12a, 12b, 12c) aufweist, wobei mindestens zwei gegensinnig wirkende Simulationsspulen (12a) zur Erzeugung der Vertikalkomponente (20a), mindestens eine Simulationsspule (12b) zur Erzeugung der Querkomponente (20b) und mindestens zwei gegensinnig wirkende Simulationsspulen (12c) zur Erzeugung der Längskomponente (20c) des Simulations-Magnetfeldes (20a, 20b, 20c) dienen.

5. Vorrichtung nach einem der Ansprüche 1 bis 4,
**dadurch gekennzeichnet,**
**dass** die Magnetfeld-Sensoranordnung (10) Magnetfeldsensoren (10) aufweist, die in einer Ebene der jeweiligen Querschnittsfläche der Entmagnetisierspulen (8) und/oder Simulationsspulen angeordnet sind.

6. Verwendung der Vorrichtung (2) nach einem der Ansprüche 1 bis 5, **gekennzeichnet durch**
eine Befestigung an einem nicht magnetischen Landungssteg (6) oder an einer Kaimauer.

7. Verwendung der Vorrichtung (2) nach Anspruch 6,
**dadurch gekennzeichnet, dass**
die Befestigung höhenverstellbar ist.

8. Erste erweiterte Vorrichtung (5) zur Entmagnetisierung und magnetischen Signaturvermessung eines stationär befindlichen Schiffskörpers (4) und zur Simulation eines Magnetfeldes (20a, 20b, 20c),
**gekennzeichnet durch**
zwei erfindungsgemäße Vorrichtungen (2) nach einem der Ansprüche 1 bis 5, die horizontal an gegenüberliegenden Seiten des Schiffskörpers (4) in dessen Längsrichtung positionierbar sind.

9. Verwendung der ersten erweiterten Vorrichtung nach Anspruch 8,
**gekennzeichnet durch**
eine Befestigung in einem nicht magnetischen Schwimmdock oder Trockendock.

10. Zweite erweiterte Vorrichtung zur Entmagnetisierung und magnetischen Signaturvermessung eines stationär befindlichen Schiffskörpers (4) und zur Simulation eines Magnetfeldes (20a, 20b, 20c), **gekennzeichnet durch** drei erfindungsgemäße Vorrichtungen (2) nach einem der Ansprüche 1 bis 5, die horizontal an gegenüberliegenden Seiten des Schiffskörpers (4) und unter dem Schiffskörper (4) in dessen Längsrichtung positionierbar sind.

11. Verwendung der zweiten erweiterten Vorrichtung nach Anspruch 10 **gekennzeichnet durch**
eine Befestigung in einem nicht magnetischen Schwimmdock oder Trockendock.

12. Dritte erweiterte Vorrichtung zur Entmagnetisierung und magnetischen Signaturvermessung eines stationär befindlichen Schiffskörpers (4) und zur Simulation eines Magnetfeldes (20a, 20b, 20c),
**gekennzeichnet durch**
eine erfindungsgemäße Vorrichtung nach einem der Ansprüche 1 bis 5 oder zwei erfindungsgemäße Vorrichtungen (2) nach einem der Ansprüche 1 bis 5, die horizontal an gegenüberliegenden Seiten in Längsrichtung des Schiffskörpers (4) positionierbar sind, und eine weitere Entmagnetisierspulen-Anordnung, die unter dem Schiffskörper (4) positionierbar ist und die eine einzige Entmagnetisierspule (8) aufweist, deren Querschnittsfläche sich mindestens über die gesamte Länge des Schiffskörpers (4) erstreckt und deren Flächennormale orthogonal zur Längsrichtung des Schiffskörpers (4) ausgerichtet ist, sodass außerhalb der Entmagnetisierspule (8) ein feststehendes magnetisches Wechselfeld erzeugbar ist, oder die mindestens zwei Entmagnetisierspulen (8) aufweist, deren Querschnittsflächen in Längsrichtung des Schiffskörpers (4) nebeneinander angeordnet und deren Flächennormalenhorizontal orthogonal zur Längsrichtung des Schiffskörpers (4) ausgerichtet sind, sodass außerhalb der Entmagnetisierspulen (8) ein in Längsrichtung des Schiffskörpers (4) fortschreitendes magnetisches Wechselfeld (30a, 30b) erzeugbar ist.

13. Verwendung der dritten erweiterten Vorrichtung nach Anspruch 12 **gekennzeichnet durch**
eine Befestigung in einem nicht magnetischen Schwimmdock oder Trockendock.

## Claims

1. A device (2) for demagnetizing and for measuring the magnetic signature of a stationary hull (4) and for simulating a magnetic field (20a, 20b, 20c), comprising a demagnetization coil assembly (8), a magnetic field sensor assembly (10) and a simulation coil assembly (12a, 12b, 12c),
**characterized in that**
the device (2) can be positioned horizontally next to the hull (4) on one side in the longitudinal direction of the hull (4),
the demagnetization coil assembly (8) having a single demagnetization coil (8), the cross-sectional area of said demagnetization coil extending at least across the entire length of the hull (4) and the surface normal of said demagnetization coil being oriented orthogonally to the longitudinal direction of the hull (4), a stationary alternating magnetic field thus being producible outside the demagnetization coil (8), or the demagnetization coil assembly having at least two demagnetization coils (8), the cross-sectional areas of said demagnetization coils being disposed next to one another in the longitudinal direction of the hull (4) and the surface normals of said demagnetization coils being oriented orthogonally to the longitudinal direction of the hull (4), an alternating magnetic field (30a, 30b) progressing in the longitudinal direction of the hull (4) thus being producible outside the demagnetization coils (8).

2. The device according to claim 1,
**characterized in that**
the progressing alternating magnetic field (30a, 30b) has a horizontal transverse component (30b) and a longitudinal component (30a) in relation to the longitudinal direction of the hull (4).

3. The device according to claim 1 or 2,
**characterized in that**
the cross-sectional areas of the simulation coils (12a, 12b, 12c) are disposed next to one another in the longitudinal direction of the hull (4) and that their surface normals are oriented in a horizontal manner, a stationary simulated magnetic field (20a, 20b, 20c) which comprises a vertical component (20a), a transverse component (20b) and a longitudinal component (20c) in relation to the longitudinal direction of the hull (4) thus being producible outside the simulation coils (12a, 12b, 12c).

4. The device according to claim 3,
**characterized in that**
the simulation coil assembly (12a, 12b, 12c) has at least five simulation coils (12a, 12b, 12c), at least two opposite simulation coils (12a) being used for producing the vertical component (20a), at least one simulation coil (12b) being used for producing the transverse component (20b) and at least two counteracting simulation coils (12c) being used for producing the longitudinal component (20c) of the simulated magnetic field (20a, 20b, 20c).

5. The device according to any one of claims 1 to 4,
**characterized in that**
the magnetic field sensor assembly (10) has magnetic field sensors (10) which are disposed in a plane of the respective cross-sectional areas of the demagnetization coils (8) and/or simulation coils.

6. A use of the device (2) according to any one of claims 1 to 5, **characterized in that**
the device is fixed to a non-magnetic jetty (6) or to a quay wall.

7. The use of the device (2) according to claim 6,
**characterized in that**
the device is fixed in a height-adjustable manner.

8. A first enhanced device (5) for demagnetizing and for measuring the magnetic signature of a stationary hull (4) and for simulating a magnetic field (20a, 20b, 20c),
**characterized by**
two devices (2) according to the invention according to any one of claims 1 to 5 which can be positioned in a horizontal manner on opposite sides of the hull (4) in its longitudinal direction.

9. A use of the first enhanced device according to claim 8,
**characterized in that**
the first enhanced device is fixed in a non-magnetic floating dock or dry dock.

10. A second enhanced device for demagnetizing and for measuring the magnetic signature of a stationary hull (4) and for simulating a magnetic field (20a, 20b, 20c),
**characterized by**
three devices (2) according to the invention according to any one of claims 1 to 5 which can be positioned in a horizontal manner on opposite sides of the hull (4) and below the hull (4) in its longitudinal direction.

11. A use of the second enhanced device according to claim 10,
**characterized in that**
the second enhanced device is fixed in a non-magnetic floating dock or dry dock.

12. A third enhanced device for demagnetizing and for measuring the magnetic signature of a stationary hull (4) and for simulating a magnetic field (20a, 20b, 20c),
**characterized by**
one device according to the invention according to any one of claims 1 to 5 or two devices (2) according to the invention according to any one of claims 1 to 5 which can be positioned in a horizontal manner on opposite sides in the longitudinal direction of the hull (4), and an additional demagnetization coil assembly which can be positioned below the hull (4) and which has a single demagnetization coil (8), the cross-sectional area of said demagnetization coil extending at least across the entire length of the hull (4) and the surface normal of said demagnetization coil being oriented orthogonally to the longitudinal direction of the hull (4), a stationary alternating magnetic field thus being producible outside the demagnetization coil (8), or which has at least two demagnetization coils (8), the cross-sectional areas of said demagnetization coils being disposed next to one another in the longitudinal direction of the hull (4) and the surface normals of said demagnetization coils being oriented in a horizontal manner orthogonally to the longitudinal direction of the hull (4), an alternating magnetic field (30a, 30b) progressing in the longitudinal direction of the hull (4) thus being producible outside the demagnetization coils (8).

13. A use of the third enhanced device according to claim 12,
**characterized in that**
the third enhanced device is fixed in a non-magnetic floating dock or dry dock.

## Revendications

1. Dispositif (2) pour la désaimantation et pour la mesure de la signature magnétique d'une coque (4) stationnaire et pour la simulation d'un champ magnétique (20a, 20b, 20c), le dispositif comprenant un agencement (8) de bobine de désaimantation, un agencement (10) de capteur de champ magnétique et un agencement (12a, 12b, 12c) de bobine de simulation,
**caractérisé en ce que**
le dispositif (2) peut être positionné horizontalement à côté de la coque (4) sur un côté dans le sens longitudinal de la coque (4), l'agencement (8) de bobine de désaimantation ayant une seule bobine de désaimantation (8), la section transversale de la bobine de désaimantation s'étendant au moins sur toute la largeur de la coque (4) et la normale à la surface de la bobine de désaimantation étant orientée de manière orthogonale au sens longitudinal de la coque (4), un champ magnétique alternatif stationnaire donc pouvant être produit en dehors de la bobine de désaimantation (8), ou l'agencement de bobine de désaimantation ayant au moins deux bobines de désaimantation (8), les sections transversales de bobines de désaimantation étant disposées à côté l'une à l'autre dans le sens longitudinal de la coque (4) et la normale à la surfaces de bobines de désaimantation étant orientée de manière orthogonale au sens longitudinal de la coque (4), un champ magnétique (30a, 30b) alternatif progressant dans le sens longitudinal de la coque (4) donc pouvant être produit en dehors des bobines de désaimantation (8).

2. Dispositif selon la revendication 1,
**caractérisé en ce que**
le champ magnétique (30a, 30b) alternatif progressant a une composante transversale (30b) horizontale du champ magnétique alternatif et une composante longitudinale (30a) du champ magnétique alternatif par rapport au sens longitudinal de la coque (4).

3. Dispositif selon la revendication 1 ou la revendication 2,
**caractérisé en ce que**
les sections transversales de bobines de simulation (12a, 12b, 12c) sont disposées à côté l'une à l'autre dans le sens longitudinal de la coque (4) et leurs normales à la surface sont disposées horizontalement, un champ magnétique (20a, 20b, 20c) simulé stationnaire qui comprend une composante verticale (20a), une composante transversale (20b) et une composante longitudinale (20c) par rapport au sens longitudinal de la coque (4) donc pouvant être produit en dehors de bobines de simulation (12a, 12b, 12c).

4. Dispositif selon la revendication 3,
**caractérisé en ce que**
l'agencement (12a, 12b, 12c) de bobine de simulation a au moins cinq bobines de simulation (12a, 12b, 12c), au moins deux bobines de simulation (12a) d'effet contraire étant utilisées pour la production de la composante verticale (20a), au moins une bobine de simulation (12b) étant utilisée pour la production de la composante transversale (20b) et au moins deux bobines de simulation (12c) d'effet contraire étant utilisées pour la production de la composante longitudinale (20c) du champ magnétique (20a, 20b, 20c) simulé.

5. Dispositif selon l'une quelconque des revendications 1 à 4,
**caractérisé en ce que**
l'agencement (10) de capteur de champ magnétique a des capteurs de champ magnétique (10) qui sont disposés dans une plane de la section transversale respective de la bobine de désaimantations (8) et/ou de bobines de simulation.

6. Utilisation du dispositif (2) selon l'une quelconque des revendications 1 à 5,
**caractérisé en ce que**
le dispositif est fixé à un embarcadère (6) antimagnétique ou à un mur de quai.

7. Utilisation du dispositif (2) selon la revendication 6,
**caractérisé en ce que**
le dispositif est réglable en hauteur.

8. Premier dispositif (5) accru pour la désaimantation et pour la mesure de la signature d'une coque (4) stationnaire et pour la simulation d'un champ magnétique (20a, 20b, 20c),
**caractérisé par**
deux dispositifs (2) selon l'invention et selon l'une quelconque des revendications 1 à 5 qui peuvent être positionnés horizontalement sur des côtés opposés de la coque (4) dans son sens longitudinal.

9. Utilisation du premier dispositif accru selon la revendication 8, **caractérisé en ce que**
le premier dispositif accru est fixé à un quai flottant antimagnétique ou à un quai sec antimagnétique.

10. Deuxième dispositif accru pour la désaimantation et pour la mesure de la signature magnétique d'une coque (4) stationnaire et pour la simulation d'un champ magnétique (20a, 20b, 20c),
**caractérisé par**
trois dispositifs (2) selon l'invention et selon l'une quelconque des revendications 1 à 5 qui peuvent être positionnés horizontalement sur des côtés opposés de la coque (4) et au-dessous de la coque (4) dans ses sens longitudinal.

11. Utilisation du deuxième dispositif accru selon la revendication 10, **caractérisé en ce que**
le deuxième dispositif accru est fixé dans un quai flottant antimagnétique ou dans un quai sec antimagnétique.

12. Troisième dispositif accru pour la désaimantation et pour la mesure de la signature magnétique d'une coque (4) stationnaire et pour la simulation d'un champ magnétique (20a, 20b, 20c),
**caractérisé par**
un dispositif selon l'invention et selon l'une quelconque des revendications 1 à 5 ou deux dispositifs (2) selon l'invention et selon l'une quelconque des revendications 1 à 5 qui peuvent être positionnés horizontalement sur des côtés opposés dans le sens longitudinal de la coque (4), et un autre agencement de bobine de désaimantation qui peut être positionné au-dessous de la coque (4) et qui a une seule bobine de désaimantation (8), la section transversale de la bobine de désaimantation s'étendant au moins sur toute la largeur de la coque (4) et la normale à la surface de la bobine de désaimantation étant orientée de manière orthogonale au sens longitudinal de la coque (4), un champ magnétique alternatif stationnaire donc pouvant être produit en dehors de la bobine de désaimantation (8), ou qui a au moins deux bobines de désaimantation (8), les sections transversales de bobines de désaimantations étant disposées à côté l'une à l'autre dans le sens longitudinal de la coque (4) et leurs normales à la surface horizontales de bobines de désaimantation étant orientées de manière orthogonale au sens longitudinal de la coque (4), un champ magnétique (30a, 30b) alternatif progressant dans le sens longitudinal de la coque (4) donc pouvant être produit en dehors des bobines de désaimantation (8).

13. Utilisation du troisième dispositif accru selon la revendication 12, **caractérisé en ce que**
le troisième dispositif accru est fixé dans un quai flottant antimagnétique ou dans un quai sec antimagnétique.
